**Europäisches Patentamt**

(19) **European Patent Office**

**Office européen des brevets**

(11) Veröffentlichungsnummer: **0 027 496**

**A1**

(12) # EUROPÄISCHE PATENTANMELDUNG

(21) Anmeldenummer: **80103589.0**

(22) Anmeldetag: **25.06.80**

(51) Int. Cl.³: **H 04 R 25/02**
**H 05 K 3/36**

(30) Priorität: **17.10.79 DE 2941951**

(43) Veröffentlichungstag der Anmeldung:
**29.04.81 Patentblatt 81/17**

(84) Benannte Vertragsstaaten:
**AT BE DE FR GB IT LU NL SE**

(71) Anmelder: **ROBERT BOSCH GMBH**
**Postfach 50**
**D-7000 Stuttgart 1(DE)**

(72) Erfinder: **Eggert, Albert, Ing.(grad.)**
**Zwickauer Damm 145**
**D-1000 Berlin 47(DE)**

(72) Erfinder: **Gahleitner, Erwin**
**Binger Strasse 84**
**D-1000 Berlin 31(DE)**

(72) Erfinder: **Köpke, Wolfgang, Ing.(grad.)**
**Prinzregentenstrasse 7**
**D-1000 Berlin 31(DE)**

(72) Erfinder: **Müller, Manfred**
**Säntisstrasse 142a**
**D-1000 Berlin 48(DE)**

(72) Erfinder: **Raupach, Gerhard**
**Wismarer Strasse 26**
**D-1000 Berlin 45(DE)**

(72) Erfinder: **Schmidt, Wolfgang, Ing.**
**Schrammstrasse 5**
**D-1000 Berlin 31(DE)**

(74) Vertreter: **Schmidt, Hans-Ekhardt**
**Robert Bosch GmbH Geschäftsbereich Elektronik**
**Patent- und Lizenzabteilung Forckenbeckstrasse 9-13**
**D-1000 Berlin 33(DE)**

(54) **Hörgerät mit einer Leiterplatte als Träger für Leitungsbahnen sowie elektrische und mechanische Bauelemente und Baustufen.**

(57) Es wird ein Hörgerät vorgeschlagen, das eine Hauptleiterplatte (10) mit mehreren Stecker- und/oder Buchsenelementen (50) enthält. Auf die Stecker- und/oder Buchsenelemente sind Leiterplatten-Baueinheiten (11, 12, 13) mit entsprechenden Buchsen- und/oder Steckerelementen (48) aufsteckbar. Die Abmessungen der Leiterplatten-Baueinheiten sind derart gewählt, daß wahlweise eine oder mehrere Leiterplatten-Baueinheiten auf der Hauptleiterplatte Platz finden. Die Leiterplatten-Baueinheiten bestehen aus einer länglichen Leiterplatte (45), an deren Endbereichen je ein Formkörper (46) mit Buchsen- und/oder Steckerelementen (48), beispielsweise mindestens ein Einstellwiderstand (55) und/oder eine Anschlußbuchse (54) für den Stecker (56) einer Hörerschnur (57) sowie eine Blende (53) für den Einstellwiderstand, befestigt sind.

Fig. 1

35/79
EK/PLI Scht/Li
17. Okt.  1979


ROBERT BOSCH GMBH, 7000 Stuttgart

Hörgerät mit einer Leiterplatte als Träger
für Leitungsbahnen sowie elektrische und
mechanische Bauelemente und Baustufen


Stand der Technik

Die Erfindung geht von einem Hörgerät nach der Gattung
des Hauptanspruchs aus.

Es ist schon ein tragbares Hörgerät (DE-GM 72 25 080)
bekannt, das eine Leiterplatte enthält, die Leitungsbahnen sowie elektrische und mechanische Bauelemente
und Baustufen trägt. Form und Abmessungen der Leiterplatte dieses Hörgerätes sind so gewählt, daß mit dieser Leiterplatte in der Regel nur ein Hörgerätetyp mit
einer bestimmten akustischen Verstärkung und bestimmten
Regelmöglichkeiten (zum Beispiel peak-clipping, Tonblende) realisierbar ist.

Vorteile der Erfindung

Das erfindungsgemäße Hörgerät mit den kennzeichnenden
Merkmalen des Hauptanspruchs hat den Vorteil, daß durch
die Bereitstellung von verschieden bestückten steckbaren
Leiterplatten-Baueinheiten sich zahlreiche Hörgerätetypen durch entsprechende Kombination der Baueinheiten
realisieren lassen. Beispielsweise kann die Hörgeräteschaltung auf je eine Leiterplatten-Baueinheit mit einem
Vorverstärker, einer Tonblende und einem Endverstärker
aufgeteilt sein. Dadurch, daß es von jeder Leiterplatten-
Baueinheit mindestens zwei Varianten gibt, lassen sich
derart viele Kombinationen bilden, daß für fast jede Art
der Hörbehinderung ein optimal angepaßtes Hörgerät
bereitgestellt werden kann. Als weiterer Vorteil ist anzusehen, daß durch die steckbaren Leiterplatten-Baueinheiten Prüf-, Abgleich- und Reparaturarbeiten erheblich
vereinfacht werden können.

Durch die in den Unteransprüchen aufgeführten Maßnahmen
sind vorteilhafte Weiterbildungen und Verbesserungen des
im Hauptanspruch angegebenen Hörgerätes möglich. Besonders
vorteilhaft ist ein Hörgerät, bei dem die länglichen
Leiterplatten-Baueinheiten an ihren Endbereichen vor den
Formkörpern noch je ein Halteelement für weitere elektrische Bauelemente tragen. Die weiteren elektrischen Bauelemente sind vorzugsweise Einstellwiderstände bzw. Potentiometer oder elektrische Anschlußbuchsen für den Stecker
einer Hörerschnur. Liegen die Einstellelemente der Einstellwiderstände bzw. Potentiometer und die Einführöffnung
der Anschlußbuchse an der Außenseite der Leiterplatten-
Baueinheiten, dann sind diese, wenn die Hauptleiterplatte
mit den aufgesteckten Leiterplatten-Baueinheiten in das
Hörgerätegehäuse eingesteckt ist, durch eine entsprechende
Öffnung des Gehäuses von außen her zugänglich.

Zeichnung

Ein Ausführungsbeispiel der Erfindung ist in der Zeichnung
anhand mehrerer Figuren dargestellt und in der nachfolgenden Beschreibung näher erläutert. Die Zeichnung zeigt in

Fig. 1   eine perspektivische Ansicht des erfindungsgemäßen
         Hörgerätes in auseinandergezogenem Zustand und

Fig. 2   eine perspektivische Ansicht einer erfindungs-
         gemäßen Leiterplatten-Baueinheit in auseinander-
         gezogenem Zustand.

Beschreibung der Erfindung

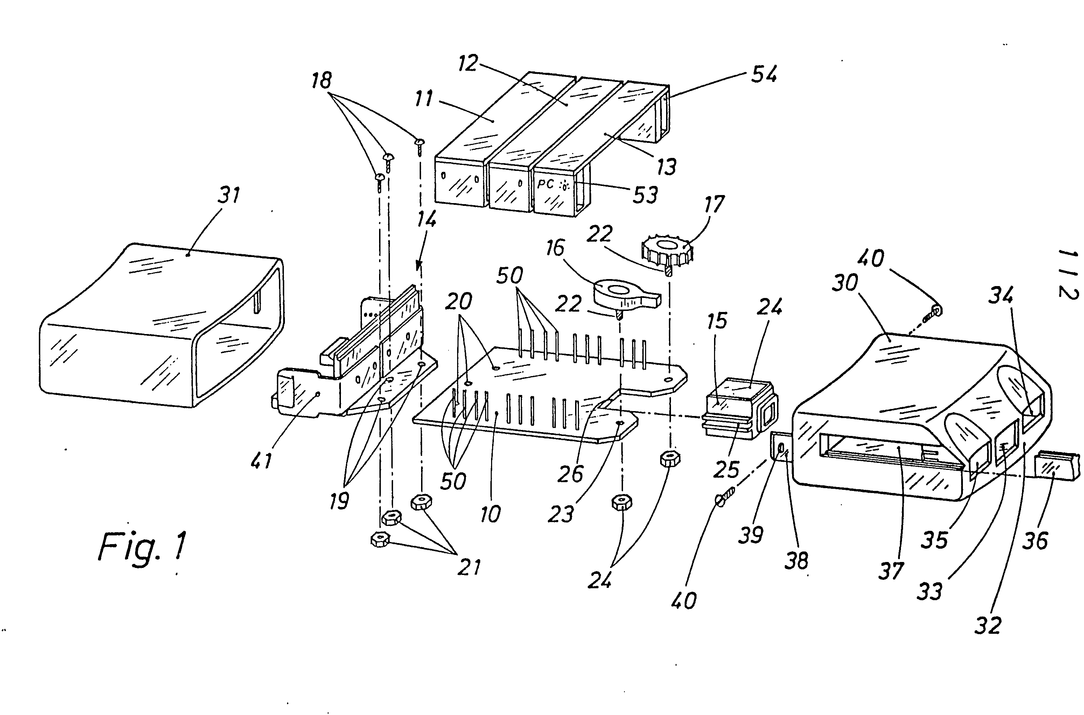

Kernstück eines erfindungsgemäßen Hörgerätes nach Fig. 1
ist eine Hauptleiterplatte 10, die als Träger für Leiterplatten-Baueinheiten 11, 12, 13, für einen Batteriehalter 14, eine Mikrofoneinheit 15, einen Schalter 16 und
einen Einstellwiderstand 17 (im folgenden Einsteller
genannt) dient. Mit Schrauben 18, deren Schäfte durch
Öffnungen 19 des Batteriehalters 14 und durch Öffnungen 20
der Hauptleiterplatte 10 passen, sowie mit entsprechenden
Muttern 21 ist der Batteriehalter an der Hauptleiterplatte
befestigt. Die Befestigung kann auch mittels Niete, vorzugsweise mittels Hohlniete, erfolgen. Zum Befestigen des
Schalters 16 und des Einstellers 17 sind fest mit diesen
Bauteilen verbundene Gewindestifte 22 vorgesehen, die durch
Öffnungen 23 der Hauptleiterplatte 10 passen und auf die
Muttern 24 von der Unterseite der Hauptleiterplatte her aufgeschraubt werden. Die Mikrofoneinheit 15 enthält an zwei
gegenüberliegenden Außenseiten eine Führungsnut 25, die die
Mikrofoneinheit nach dem Einschieben in einen Einschnitt 26
der Hauptleiterplatte 10 festhält.

Im zusammengesetzten Zustand umgibt die Hauptleiterplatte 10 mit den angesteckten bzw. angeschraubten Bauelementen und Baueinheiten ein Hörgerätegehäuse, das aus einem Gehäuseteil 30 und einer Kappe 31 besteht. Der Gehäuseteil 30 enthält in einer Stirnseite 32 je eine Öffnung 33, 34, 35 zum Durchtritt der Bedienungselemente des Schalters 16 und des Einstellers 17 und zum Schalleintritt für das Mikrofon 15.

Das Gehäuse enthält ferner mindestens eine durch einen Schieber 36 verschließbare längliche Öffnung 37, deren Bedeutung weiter unten beschrieben wird. Zwei Laschen 38 an gegenüberliegenden Schmalseiten des Gehäuseteils 30 enthalten je ein Loch 39. Durch die Löcher sind bei in dem Gehäuseteil 30 eingeführter, komplett bestückter Hauptleiterplatte 10 Schrauben 40 gesteckt und in entsprechende Öffnungen 41 des Batteriehalters 14 eingeschraubt, um die Leiterplatte in dem Gehäuseteil 30 festzuhalten.

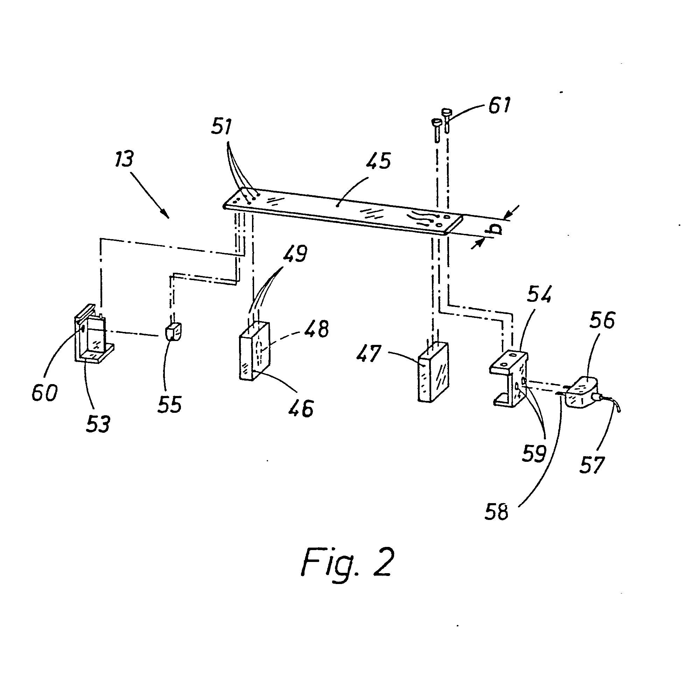

Die Leiterplatten-Baueinheiten 11, 12, und 13, das sind schmale U- bzw. brückenförmige Steckeinheiten, sind folgendermaßen aufgebaut; vgl. Fig. 2.

Jede Leiterplatten-Baueinheit besteht aus einer länglichen, rechteckförmigen Leiterplatte 45, die es je nach der gewünschten Bestückung in verschiedenen Breiten b geben kann. Für den Vorverstärker, die Tonblende und den Endverstärker des Hörgerätes gibt es je einen Leiterplattentyp und diesen in unterschiedlichen Varianten.

Die längliche Leiterplatte 45 trägt in ihren Endbereichen je einen Formkörper 46 und 47, der Buchsen 48 enthält. Die Buchsen sind derart angeordnet, daß sie mit entsprechenden Steckerstiften 50 der Hauptleiterplatte 10 korrespondieren. Zum Befestigen der Formkörper 46, 47 an der länglichen Leiterplatte 45 dienen mit den Buchsen 48 verbundene Stifte 49,
die in entsprechende Löcher 51 der Leiterplatte 45 passen
und die mit Leitungsbahnen, zum Beispiel durch Löten,
elektrisch verbunden sind.

Die Formkörper 46 und 47 sind nach dem Ausführungsbeispiel
in Fig. 2 etwas vom Rand der länglichen Leiterplatte 45
zurückversetzt (vgl. auch Fig. 1), so daß die Leiterplatte
neben einem Formkörper noch ein oder zwei Einstellwiderstände 55 oder eine Anschlußbuchse 54 für einen zum Beispiel
zweipoligen Stecker 56 einer Hörerschnur 57 tragen kann.
Zum Einführen der Steckerstifte 58 des Steckers 56 enthält
die Anschlußbuchse 54 zwei Einführöffnungen 59. Die Anschlußbuchse 54 ist mit der Leiterplatte 45 durch Niete 61 oder
Schrauben verbunden.

Vor dem Einstellwiderstand 55 ist zweckmäßigerweise eine
Blende 53 mit je einer Öffnung 60 zum Durchführen eines
Einstellwerkzeuges für jeden Einstellwiderstand vorgesehen.
Es kann auch vorteilhaft sein, die Einstellwiderstände
mittels in der Zeichnung nicht dargestellter Halteklammern
rastend auf dem Formkörper 46 zu befestigen, so daß ein einfacher Austausch der Einstellwiderstände möglich ist.

Die Blenden 53 und die Anschlußbuchse 54 sind derart bemessen, daß die Öffnungen 60 der Blenden und die Öffnungen 59
der Anschlußbuchse durch die Gehäuseöffnung 37 frei zugänglich sind.

35/79
EK/PLI Scht/Li
17. Okt. 1979

ROBERT BOSCH GMBH, 7000 Stuttgart


Ansprüche

1. Hörgerät mit einer Leiterplatte als Träger für Leitungsbahnen sowie elektrische und mechanische Bauelemente und
   Baustufen, gekennzeichnet durch eine Hauptleiterplatte
   (10) mit mehreren Stecker- und/oder Buchsenelementen (50)
   und durch mit Buchsen- und/oder Steckerelementen (48) versehene Leiterplatten-Baueinheiten (11, 12, 13), deren
   Abmessungen derart gewählt sind, daß wahlweise eine Leiterplatten-Baueinheit oder mehrere Leiterplatten-Baueinheiten
   nebeneinander mit ihren Buchsen- und/oder Steckerelementen
   auf die Stecker- und/oder Buchsenelemente der Hauptleiterplatte aufsteckbar sind.

2. Hörgerät nach Anspruch 1, dadurch gekennzeichnet, daß die
   Hauptleiterplatte (10) im wesentlichen rechteckförmig ist,
   daß die Stecker- und/oder Buchsenelemente (50) parallel zu
   zwei gegenüberliegenden Seiten der Hauptleiterplatte angeordnet sind, daß die Leiterplatten-Baueinheiten (11, 12, 13)
   die Form eines schmalen Streifens haben, an deren Enden die
   Buchsen- und /oder Steckerelemente (48) angeordnet sind.

3. Hörgerät nach Anspruch 2, dadurch gekennzeichnet, daß die
   Leiterplatten-Baueinheiten (11, 12, 13) aus einer länglichen
   Leiterplatte (45) und aus zwei an den Endbereichen der
   Leiterplatte angebrachten Formkörpern (46, 47) bestehen, die
   die Buchsen- und/oder Steckerelemente (48) aufnehmen.

4. Hörgerät nach Anspruch 3, dadurch gekennzeichnet, daß die
   Formkörper (46, 47) in einem gewissen Abstand von dem Rand
   der länglichen Leiterplatte (45) angeordnet sind und daß

35/79                              - 2 -

vor den Formkörpern mit der länglichen Leiterplatte verbundene bestimmte elektrische Bauelemente (54, 55) vorsehen sind.

5. Hörgerät nach Anspruch 4, dadurch gekennzeichnet, daß
   die bestimmten elektrischen Bauelemente Einstellwiderstände (55) bzw. Potentiometer sind.

6. Hörgerät nach Anspruch 4, dadurch gekennzeichnet, daß
   ein bestimmtes elektrisches Bauelement eine Anschlußbuchse (54) zum Anschließen eines Hörerschnur-Steckers
   (56) ist.

7. Hörgerät nach Anspruch 1 oder einem der folgenden,
   dadurch gekennzeichnet, daß die Hauptleiterplatte (10)
   an einem nicht durch die Stecker- und/oder Buchsenelemente
   belegten Randbereich mit einem Batteriehalter (14) für
   eine das Hörgerät speisende Batterie verbunden ist.

8. Hörgerät nach Anspruch 7, dadurch gekennzeichnet, daß
   die Hauptleiterplatte (10) an der dem Batteriehalter (14)
   gegenüberliegenden Seite einen Einschnitt (26) zur Aufnahme einer Mikrofoneinheit (15) enthält.

9. Hörgerät nach Anspruch 8, dadurch gekennzeichnet, daß zu
   beiden Seiten des Einschnitts (26) der Hauptleiterplatte
   (10) ein Schalter (16) und ein Einstellwiderstand (17)
   befestigt sind.

10. Hörgerät nach Anspruch 5, dadurch gekennzeichnet, daß an
    der länglichen Leiterplatte (45) vor den Einstellwiderständen (55) eine Blende (53) vorgesehen ist, die je Einstellwiderstand eine Öffnung (60) zum Durchführen eines
    Einstellwerkzeuges aufweist.

Fig. 1

112

0027496

212

*Fig. 2*

## Europäisches Patentamt

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | DE - A - 2 603 575 (MOTOROLA)<br>* Seite 5, Zeile 18 bis Seite 10, Abschnitt 2; Figuren * | 1-5 |
| | -- | |
| | DE - B - 1 232 623 (GRETZLAFF)<br>* Spalte 2, Zeile 39 bis Spalte 3, Zeile 49; Figuren * | 1,2,4, 5 |
| | -- | |
| | DE - B - 1 273 021 (A.H. JOHNSON)<br>* Patentanspruch 1; Figuren 1-4 * | 1,2 |
| | -- | |
| | US - A - 3 598 928 (G.B. HICKOX)<br>* Spalte 2, Zeile 33 bis Spalte 4, Zeile 52; Figuren * | 1 |
| | -- | |
| A | BE - A - 700 722 (PHOTRONIC INTERNATIONAL)<br>* Seite 2, Zeile 18 bis Seite 4, Zeile 1; Figuren 1a,1b * | 1 |
| | -- | |
| A | CH - A - 473 524 (AG FUR ELEKTROAKUSTIK)<br>* Patentanspruch; Unteransprüche; Figuren * | 1,10 |
| | ----- | |

### KLASSIFIKATION DER ANMELDUNG (Int Cl )

H 04 R 25/02
H 05 K 3/36

### RECHERCHIERTE SACHGEBIETE (Int Cl )

H 04 R 25/00
25/02
25/04
H 05 K 1/14
3/36

### KATEGORIE DER GENANNTEN DOKUMENTE

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

Der vorliegende Recherchenbericht wurde für alle Patentansprüche erstellt

| Recherchenort | Abschlußdatum der Recherche | Prüfer |
|---|---|---|
| Den Haag | 23-01-1981 | MINNOYE |

EPA form 1503.1 06.78